(19) Europäisches Patentamt
European Patent Office
Office européen des brevets

(11) Publication number: **0 017 374**
**A1**

(12) **EUROPEAN PATENT APPLICATION**

(21) Application number: 80300812.7

(22) Date of filing: 18.03.80

(51) Int. Cl.$^3$: H 01 S 3/06

(30) Priority: 29.03.79 GB 7911036

(43) Date of publication of application: 15.10.80 Bulletin 80/21

(84) Designated Contracting States: AT BE CH DE FR IT NL

(71) Applicant: ITT INDUSTRIES, INC.
320 Park Avenue
New York, NY 10 022(US)

(72) Inventor: Kirkby, Paul Anthony
42 St John's Avenue
Harlow Essex(GB)

(74) Representative: Laurence, Simon French et al,
ITT UK Patent Department Maidstone Road
Foots Cray Sidcup DA14 5HT(GB)

(54) **Injection laser devices.**

(57) A narrow single stripe contact double heterostructure injection laser device in which, in the laser chip 80, dielectric waveguiding in the transverse direction in avoided and gain guiding promoted thereby producing an astigmatic optical output with a relatively wide spectral emission and near field pattern. The astigmatism is corrected with an astigmatic microlens 83 adjacent the output facet of the laser chip. Preferably the microlens is substantially semicyclindrical.

y
80
x
83
82
z
81

FIG.8

EP 0 017 374 A1

P.A. Kirkby - 6

# INJECTION LASER DEVICES

This invention relates to stripe contact double heterostructure injection laser devices.

The simple form of double heterostructure $Ga_{(1-x)}Al_xAs$ ($x \geq 0$) laser, having a flat active layer sandwiched between two flat layers of material having a higher band-gap and lower refractive index than that of the material of the active layer, typically has a much greater efficiency than homostructure GaAs lasers. This is because the heterostructure provides a measure of optical dielectric waveguiding and injected carrier confinement. The refractive index difference at the two heterojunctions provides a dielectric waveguiding effect in the direction normal to their planes, and similarly carrier confinement in this direction is provided by the difference in band-gap at these two heterojunctions. In the direction of the laser axis the heterojunctions provide no dielectric waveguiding effect and no injected carrier confinement; but then none is required. In the transverse direction both appear to be desirable in the interests of laser efficiency, but neither are provided by planar heterojunctions.

Various ways and means have been proposed for providing at least a measure of optical dielectric waveguiding, or injected carrier confinement, or both, in the transverse direction. Among these are included the buried heterojunction structure and the intersecting p-n and hetero-junction structures described in our UK Patent Specification Nos. 1 273 284, 1 494 518 and UK Patent Application No. 13957/77 (G.H.B. Thompson 10, 19, and 23-6), the parallel etched tracks structure described in our UK Patent Specification No. 1 258 360 (G.H.B. Thompson et al 12-10-1), the rid structures described in our UK Patent Specifications Nos. 1 531 238 and 1 558 642 (G.H.B. Thompson et al 20-2 and 22-4), the channelled substrate structures described in our UK Patent Specification No. 1 530 323 (P.A. Kirkby 2) and UK Patent Application No. 05811/78 (G.H.B. Thompson 25), the stress-induced laser waveguide structures described in our UK Patent Application No. 2,029083A (P.A. Kirkby 5), and the double stripe contact laser structures described in our UK Patent Specification No. 1 557 072 (C.H.L. Goodman et al 9-3). If no such steps are taken to provide dielectric waveguiding or injected carrier confinement in the transverse direction, it has been customary to confine the width of the active region, that is the population inverted region, of the laser by using a stripe contact for one of the laser electrodes, and by arranging for the active layer to be as close as possible underneath this contact so as to limit the lateral spread of the current that occurs in the intervening region. Typically the stripe contact may be 20 microns wide and situated about 2 microns above the active layer. In such a device the profile of the injected carrier concentration across the width of the active region of the lasing threshold exhibits a distinct plateau about 20 microns wide which falls away relatively steeply over the next few microns.

The present invention is concerned with single stripe contact double heterostructure injection laser devices in which the stripe contact is much narrower, in which there is substantially no plateau region in the injected carrier concentration profile measured across the width of the active region at the lasing threshold, and in which this profile produces a structure that is dielectrically fairly strongly anti-waveguiding in the transverse direction.

A laser of the type in which optical guiding occurs by the phenomenon known as 'gain guiding' exhibits astigmatism in its output as for instance has been explained in the article 'Gain Induced Guiding and Astigmatic Output Beams of GaAs Lasers' by D.D. Cook and F.R. Nash appearing in the Journal of Applied Physics, Volume 46 pages 1160-72 (April 1975). Focussing with a suitable non-astigmatic lens upon the output facet of such a laser reveals an apparent line source extending in the transverse direction, and if the laser is then advanced towards the objective by a small amount, typically about 25 microns, a second apparent line source extending in a direction perpendicular to the first. The astigmatic distance separating these apparent line sources is so small that only a very weakly astigmatic lens is required to correct the astigmatism if such a lens is placed at any significant distance, of say a few centimetres, away from the laser. Hence such a lens will have virtually no effect upon the relative angular spread of the output beam in the two directions. However if a microlens placed adjacent the laser is used to correct the astigmatism, the astigmatism of such a lens needs to be quite pronounced, and thus it will have a significant effect upon the relative angular spread of the output beam in the two directions. Under appropriate conditions this can result in an output beam that is more nearly uniform in angular spread, and thus is better suited for launching into optical fibres, and into any other types of optical systems having uniform acceptance angles.

According to the present invention there is provided a single narrow stripe contact double heterostructure injection laser device including a laser chip and associated astigmatic lens wherein the stripe contact is sufficiently narrow for there to be no significant plateau in the injected carrier distribution profile measured across the width of the laser at the lasing threshold current, characterised in that the astigmatic lens is a microlens located adjacent the output facet of the laser, and in that the astigmatic power and positioning of the microlens is such as to compensate the natural astigmatism of the laser output beam.

There follows a description of a laser device embodying the invention in a preferred form. For the purpose of comparison some properties of this laser are contrasted with those of a double stripe contact laser of the type to which reference has previously been made. The description refers to the accompanying drawings in which:-

Fig. 1 depicts a single narrow stripe contact laser,

Fig. 2 depicts a double stripe contact laser,

Fig. 3 depicts a spectral emission of the laser of Fig. 1,

Fig. 4 depicts the current density, dielectric constant and optical near field pattern profiles of the lasers of Figs. 1 and 2,

Fig. 5 and 6 depict at various power levels the near and far field patterns for the laser of Fig. 1 measured in the plane of its active layer,

Fig. 7 depicts the intermodulation performance of the laser of Fig. 1,

Fig. 8 depicts the laser of Fig. 1 mounted on a heat sink and provided with its associated microlens,

Figs. 9 and 10 depict ray diagrams for the laser and microlens system of Fig. 8,

Fig. 11 depicts the relation between microlens radius and thickness and laser astigmatism,

Fig. 12 depicts the near field patterns for the laser of Fig. 1 viewed through its associated microlens, and

Fig. 13 depicts the change in near field pattern produced by the use of a microlens placed adjacent the output facet of a laser similar in construction to that of Fig. 1.

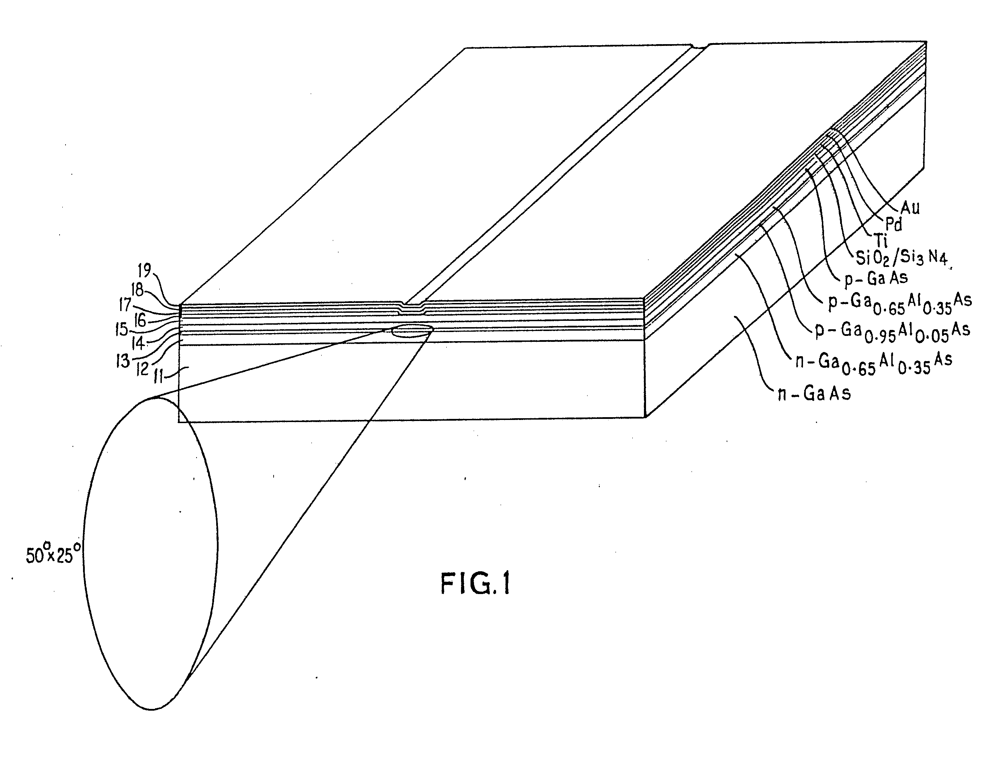

Fig. 1 depicts a single narrow stripe contact $Ga_{1-x}Al_xAs$ ($x \geq 0$) double heterostructure laser that has a GaAs n-type substrate 11 upon which four layers 12, 13 14 and 15 are grown by liquid phase epitaxy. In this instance layers 12 and 14 are respectively n-type and p-type passive layers of $Ga_{0.65}Al_{0.35}As$, and sandwich layer 13, which is the active layer, is made of the higher refractive index lower band-gap material $Ga_{0.95}Al_{0.05}As$. The uppermost layer, layer 15, is a capping layer of p-type GaAs provided so as to facilitate the provision of a good electrical contact between a metal contact layer and the underlying semiconductive material. The substrate, which is approximately 100 microns thick and 200 microns long, has a carrier concentration of between $5 \times 10^{17}$ and $2 \times 10^{18}$ per cc. The n-type passive layer 12 is tin doped to provide a nominal carrier concentration of about $5 \times 10^{17}$ per cc, and is 2 microns thick. The active layer 13 is 0.2 microns thick, and is doped with germanium or silicon to make it p-type with a carrier concentration of $3 \times 10^{17}$ per cc. The p-type passive layer 14 is germanium doped to provide a nominal carrier concentration of $7 \times 10^{17}$ per cc, and is 1 micron thick, while the capping layer 15 is germanium doped to provide a carrier concentration of $3 \times 10^{17}$ per cc, and is also 1 micron thick. The carrier concentration in the two passive layers 12 and 14 have been quoted as nominal values because the values are those calculated for GaAs, whereas the presence of the relatively large amount of aluminium in these two layers is liable to have made the actual carrier concentrations somewhat lower.

Electrical contact with the exposed surface of the capping layer 15 is restricted to a stripe 3 microns wide by an electrically insulating film 16. This film may be made for instance of silica, silicon nitride, or alumina. A preferred way of providing the film is to place the semiconductive material on a graphite susceptor in a 15 cm diameter vacuum vessel containing 4% silane in ammonia to pressure of about 0.3 torr. Nitrous oxide is bled into this to produce a total pressure of about 0.5 torr (as registered by a thermo-couple vacuum gauge). Then a silica/ silicon nitride film is deposited by an r.f. excited plasma using a 500 watt 1 MHz generator adjusted to provide a susceptor temperature of 525°C. The thickness of the deposited film is typically between 0.05 and 0.10 microns. The film is deposited as a single layer extending over the whole exposed major surface of the capping layer 15, and is then divided into two by the formation of the 3 micron wide stripe. This stripe is made by etching using buffered hydrofluoric acid and conventional photolithographic masking techniques. The stripe contact electrode is provided by a 0.1 micron thick layer 17 of titanium, covered by a 0.3 micron thick layer 18 of palladium, itself covered by a 0.06 to 0.1 micron thick layer of gold. In the formation of this electrode the amount of gold has been kept small in order to minimise any increase in thermal impedance between the semiconductive material and a heat sink to which the layer is to be bonded. The completed laser is bonded to its heat sink (not shown in Fig. 1) with indium,and in the presence of a thick layer of gold,this can give rise to an increase thermal impedance attributable to the formation of a gold-indium intermetallic.

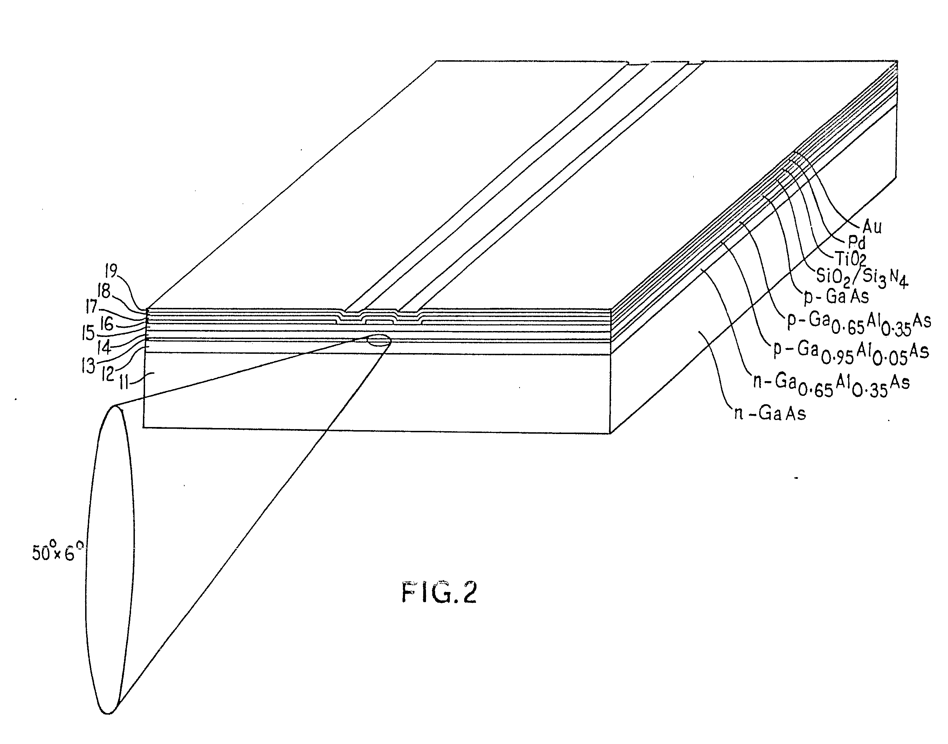

Fig. 2 depicts a double stripe contact $Ga_{1-x}Al_xAs$ ($x \geq 0$) double heterostructure laser. The composition and structure of its substrate 11 and epitaxially deposited layers 12, 13, 14 and 15 are identical with those of the single narrow stripe laser of Fig. 1. The electrically insulating layer 26 is formed in the same way as the equivalent layer 16 of the single narrow stripe laser, but is formed with two 3 micron wide stripes instead of one. The nearer edges of the two stripes are 3 microns apart. A stripe contact electrode is provided by three metallic layers 17, 18 and 19 identical in composition and thickness with the equivalent layers of the single narrow stripe laser of Fig. 1.

Examination of the near-field pattern of the single narrow stripe laser of Fig. 1 reveals a spot size measuring approximately 0.5 microns high by 9.0 microns wide (in the plane of the active layer,), whereas that of the double stripe laser of Fig. 2 measures approximately 0.5 microns high by 3.5 microns wide. The far-field patterns are also different. In both instances the polar diagram in the plane of the emission containing the laser axis and the normal to plane of the active layer shows an angle of about $50^{\circ}$ between half-power points. In the plane of the layers the angle between the half-power points is approximately $25^{\circ}$ for the single narrow stripe laser of Fig. 1, and approximately $6^{\circ}$ for the double stripe laser of Fig. 2. There is also a significant difference in the spectral output. The double stripe laser has a relatively high Q, and a single longitudinal mode tends to predominate at the expense of the others;

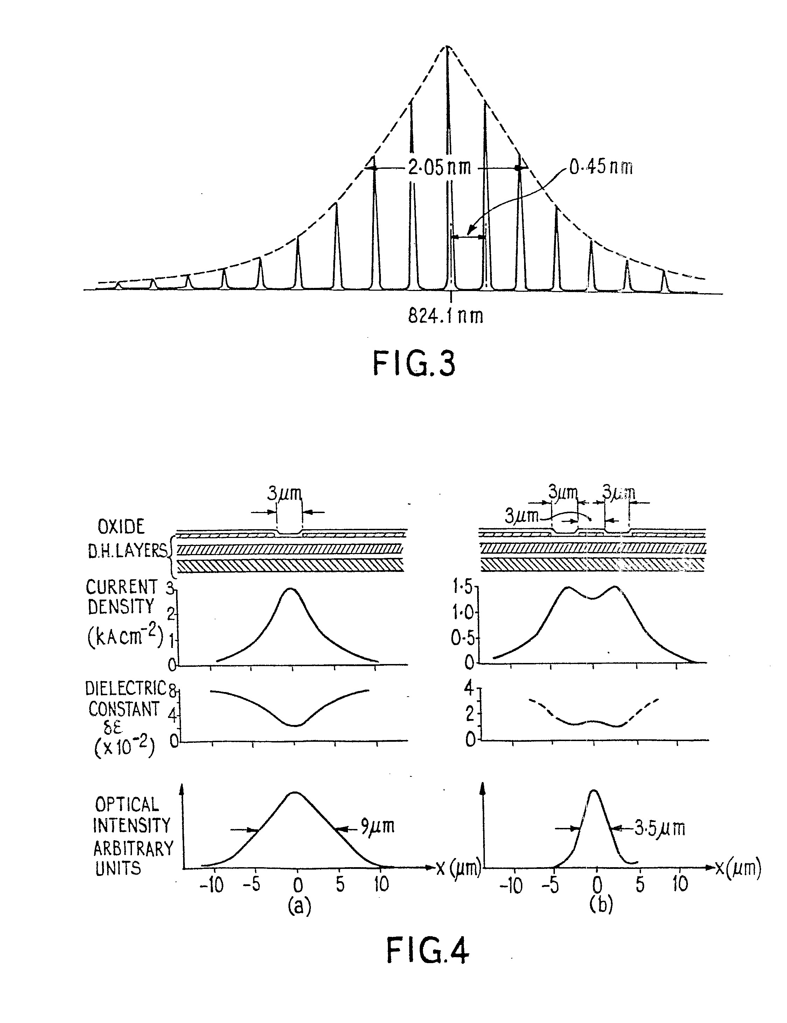

whereas in the single narrow stripe laser the Q is lower, and the spectral emission pattern shows a comb of longitudinal modes as depicted in Fig. 3.

In both instances the guiding of the light in the transverse direction is effected primarily by the shape of the injected carrier concentration profile beneath the contacts. This is illustrated in Fig. 4. The current spreads out as it flows from the stripe contact across the underlying capping layer and p-passive layer to the active layer. The injected carrier profile in the active layer is sharply peaked in the case of the single narrow stripe laser, and in the case of the double stripe laser has a double peak with a dip in between the peaks. The shape of these injected carrier concentration profiles has a dominant effect upon the refractive index variations beneath the stripes because, as a result of free carrier and band edge effects, the refractive index reduces as the carrier concentration increases. The dielectric constant profiles, also plotted in Fig. 4, show how in the case of the single narrow stripe laser a strong dielectric anti-waveguiding configuration is formed with the dielectric constant being lower beneath the axis of the stripe than at that edges, whereas in the double stripe the dip in the carrier concentration between the two stripe contacts forms a positive dielectric waveguiding configuration having a higher dielectric constant in the middle than at the edges.

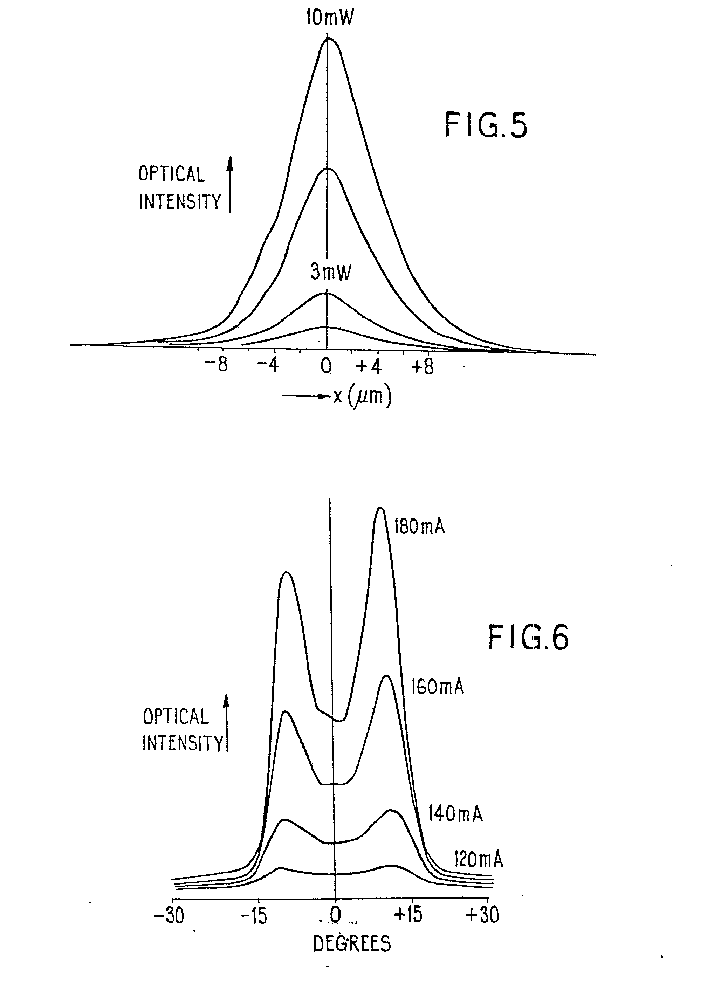

Fig. 4 clearly shows that the width of the near field pattern of the narrow stripe laser is considerably larger than that of its stripe contact. This is because of the strong defocusing effect of the dielectric anti-waveguiding configuration. The near field pattern is in fact largely determined by the sharply peaked gain profile which causes light to be greatly amplified beneath the axis of the stripe. This is rapidly diffracted off to either side, where it is absorbed in the unpumped regions. This situation is referred to as optical gain guiding, and results in a cylindrical wavefront which spreads out to form a wide far field pattern as it leaves the front facet of the laser. Examples of experimental near field and far field patterns of a single narrow stripe laser are plotted in Figs. 5 and 6. The double peaked far-field pattern of the single narrow stripe laser does not imply that the laser is operating in a high order transverse mode, but is a result of the cylindrical wavefront. The near-field clearly shows that the laser is operating in its zero order transverse mode. The double stripe laser initially operates in its zero order transverse mode at low power levels, but with increasing drive the threshold of the onset of the first order mode is reached because as the light intensity increases it uses up injected carriers most rapidly in the dip between the stripe contact. The dip therefore gets deeper so that the optical waveguiding action is strengthened to the point where it will support the first order mode. Typically this onset occurs at about 7 mW into a hemisphere, whereas a single narrow stripe laser has been operated with stability in zero order mode at up to 20 mW.

The onset of the first order mode in the double stripe laser is accompanied by a slight increase in efficiency, and so there is a corresponding slight kink in the transfer characteristic at about 7 mW. The narrow stripe laser does not show this kink, and the improved linearity allows analogue optical communication systems to be considered.

The intermodulation performance of some single narrow stripe lasers has been measured at 5 mW p-p output power into NA = 0.5 with a c.w. bias of 5 mW. The two signal frequencies $f_1$ and $f_2$ were

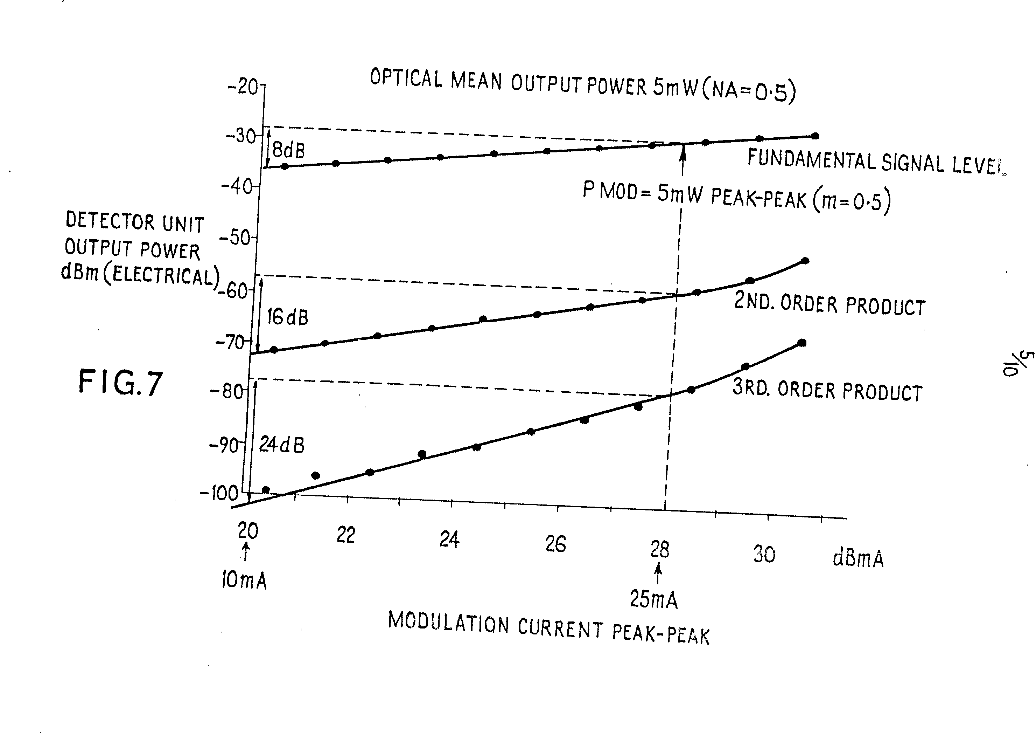

4.0 and 4.5 MHz. Second order intermodulation products ($f_1$-$f_2$) are 30 dB down and third order products are 50 dB down. The third order products vary from 40-60 dB down from laser to laser. This is illustrated in Fig. 7 which also shows that the intermodulation products reduce in a well behaved linear manner as the signal amplitude is reduced. The signal to noise ratio of the single narrow stripe laser has also been measured in an analogue system with 4 mW p-p signal and 4 mW c.w. bias. In a 5 MHz bandwidth the signal/r.m.a. noise is 56 dB, comparable to the important third order intermodulation products. Once above lasing threshold the frequency response of these lasers is flat up to well in excess of 500 MHz. The resonance peak observed in the frequency response of stripe lasers with a built-in waveguide,such as the double stripe laser,is not present. It is believed that this is a result of the heavily damped and lossy waveguide mechanism.

There have been reports of spurious excess noise occurring in optical communication links which use highly coherent laser sources. This problem has been referred to as 'modal noise' and is a serious limitation in practical analogue communication links, particularly if there are even slight misalignments in the various connectors. The problem is caused by changes in the interference speckle patterns at the connectors which occur when the source is highly coherent and its wavelength scans even by a minute amount (as it always does during modulation). The double stripe and the majority of other lasers now available usually operate c.w. in a coherent single longitudinal mode. This is usually claimed as an advantage, but from the point of view of modal noise it is highly undesirable. The high losses of the optical wave in the single narrow stripe laser reduce the quality factor of the optical resonator so that these lasers operate in a family of longitudinal modes depicted in Fig. 3 which are less coherent than those of the 20 μm and double stripes. This relatively large spectral width causes no significant dispersion problems even in silica fibre systems 10 km long at 140 Mbit/s. It does however greatly reduce the problems of modal noise so that it can be concluded that the single narrow stripe laser is well suited for digital systems, for analogue time/frequency modulated systems and for all but the most demanding amplitude modulated analogue systems.

The combination of high zero order mode power and wide near-field optical distribution (9 μm x 0.5 μm) makes the single narrow stripe laser well suited for high output power applications. The near-field distribution remains zero order transverse mode and in a stable position up to above 20 mW output into a hemisphere. The maximum output power is limited by damage to the output facet of the laser caused by the high optical flux density. The power output level at which catastrophic damage occurs is referred to as the burn-off power. The c.w. burn-off power levels are in the range 45-70 mW into a hemisphere, for single narrow stripe lasers whose output facets have been coated with a half-wavelength thickness protective coating of alumina. However the very factor which results in its high output power capability before facet damage occurs, namely its wide near-field distribution, is in some systems a disadvantage: a diffraction limited symmetrical spot is often more useful.

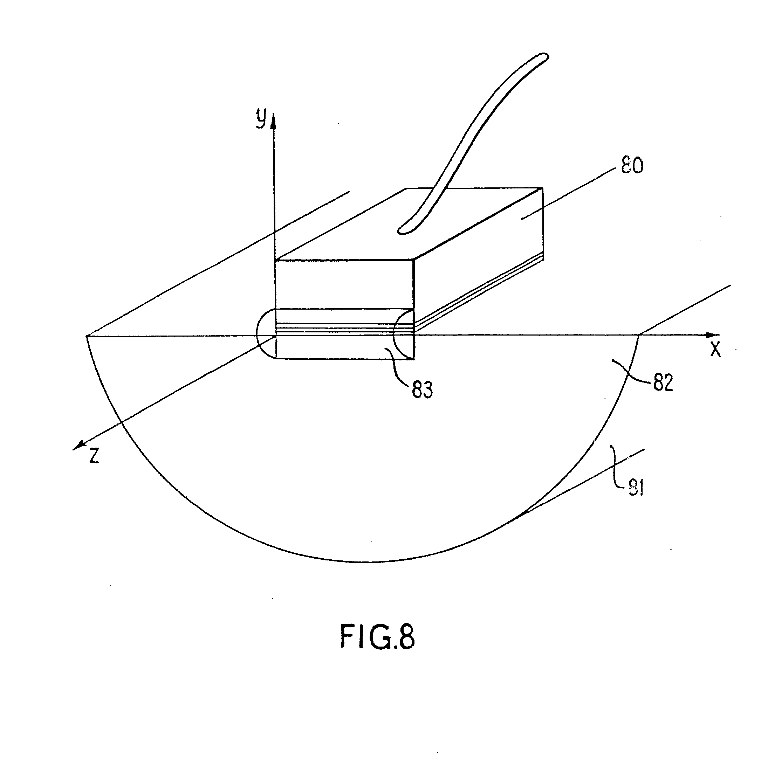

As mentioned earlier one result of gain guiding is that the wavefront of the optical wave of a single narrow stripe laser is cylindrical. When viewed from outside, the laser source therefore appears astigmatic. Focusing on the front facet of the laser gives the true optical distribution approx. 9 µm wide by 0.5 µm high. Focusing about 25 µm behind the front facet of the laser another apparent line focus is observed approximately 20 µm high by less than 1 µm wide. If the astigmatism is corrected by using a suitable lens the two line foci coincide and a source with apparent dimensions less than 1 µm x 1 µm can be obtained. The astigmatism can be corrected using a microlens as shown in Fig. 8. This shows a single narrow stripe laser 80 mounted with its stripe contact layer face downwards on a copper D-shaped header 81 having a plane end face 82. The laser is mounted with its axis aligned with the axis of the header, and its output facet substantially flush with the plane of the header end face. A plano-convex cylindrical silica microlens 83 is then mounted on the header end face with its axis lying in the plane of the active layer of the laser. In practice the active layer is so close to the laser surface that alignment of the microlens with respect to interface between the laser and the header is adequate. The microlens may be secured in position on the header for instance by means of an ultraviolet light curing adhesive. Alternatively, particularly if possible outgassing of an adhesive is likely to be a problem, the flat surface at the two ends of the microlens is metallised leaving clear the middle portion opposite the laser, and then the microlens is secured to the header by soldering, for instance with indium or with a lead/tin solder. The selection of the appropriate power of microlens may be made by examining the laser emission with the aid of a microscope objective and image converter. A line focus aligned in the plane of the layers is obtained when the microscope objective is focussed on the output facet of the laser. Then because of the astigmatism, if the laser is tracked in towards the microscope objective, a second line focus is formed after a particular distance $\underline{a}$ has been traversed, this line focus being in the direction normal to the plane of the active layer. (In general it is easier to measure the distance $\underline{a}$ by tracking the microscope objective rather than the laser, but this introduces no significant error provided that its focal length is very short compared with that of the imaging optics between the microscope objective and the image converter).

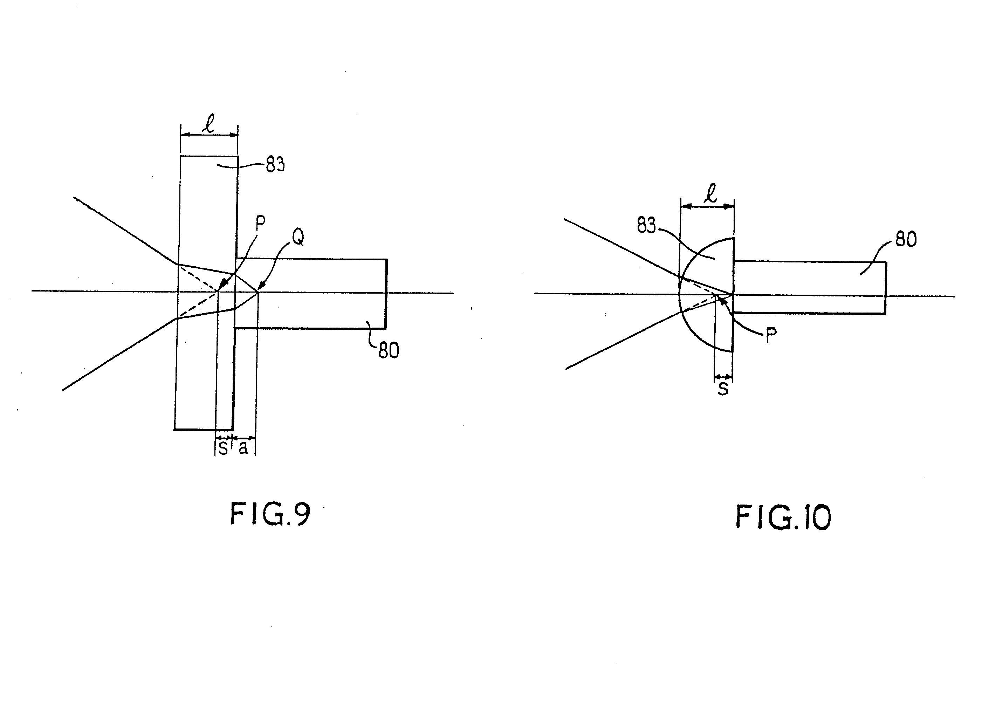

Figs. 9 and 10 are ray diagrams showing how the use of the astigmatic microlens 83 produces an apparent correct focus of both astigmatic line focuses at the point P located a distance $\underline{s}$ in front of the laser 80. In Fig. 9 the uncorrected apparent focus of the second line focus is represented as occuring at the point Q situated a distance $\underline{a}$ behind the front of the laser. (The distance $\underline{a}$ is a distance measured in air, and hence the position Q has to be represented in Fig. 9 at the position that is appropriate for a medium behind the microlens having a refractive index of unity).

If the microlens has a thickness $\underline{\ell}$, a radius of curvature $\underline{r}$, and is made of a material of refractive index $\underline{n}$, using the small angles approximation it can be seen from Snell's law that

$$s = a + \ell/n - \ell$$

and from the thick lens formula that

$$n/\ell - 1/(\ell + s) = (n - 1)/r.$$

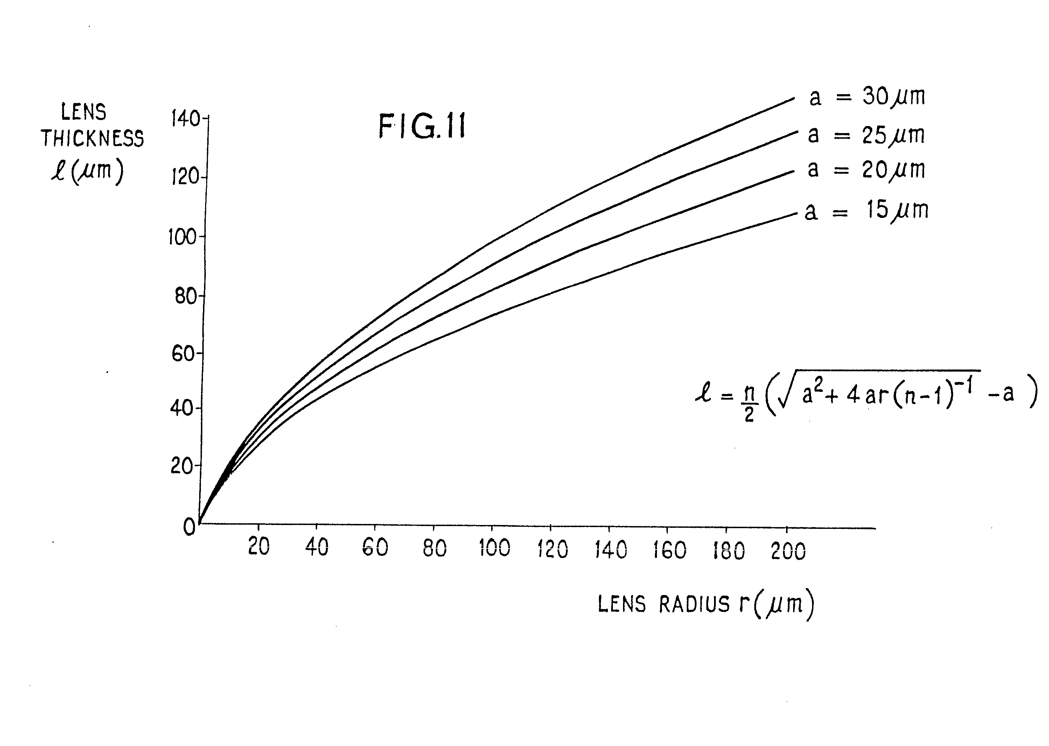

From these equations can be derived the relationships between $\underline{\ell}$, $\underline{r}$, $\underline{n}$ and $\underline{a}$ set out in the graph of Fig. 11. These curves are calculated for silica using n = 1.448.

The preferred way of making the microlenses is to polish down silica fibres with jewellers rouge. As a semicylinder produces the least distortion, fibre diameters are selected in relation to the line foci separation distance a to make each required lens thickness approximately equal to its radius of curvature.

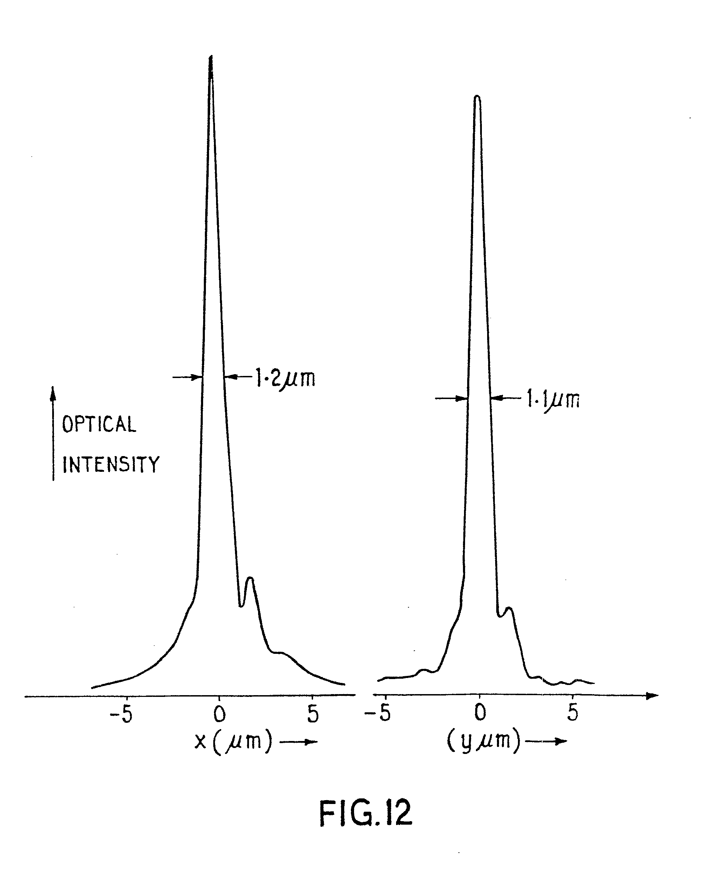

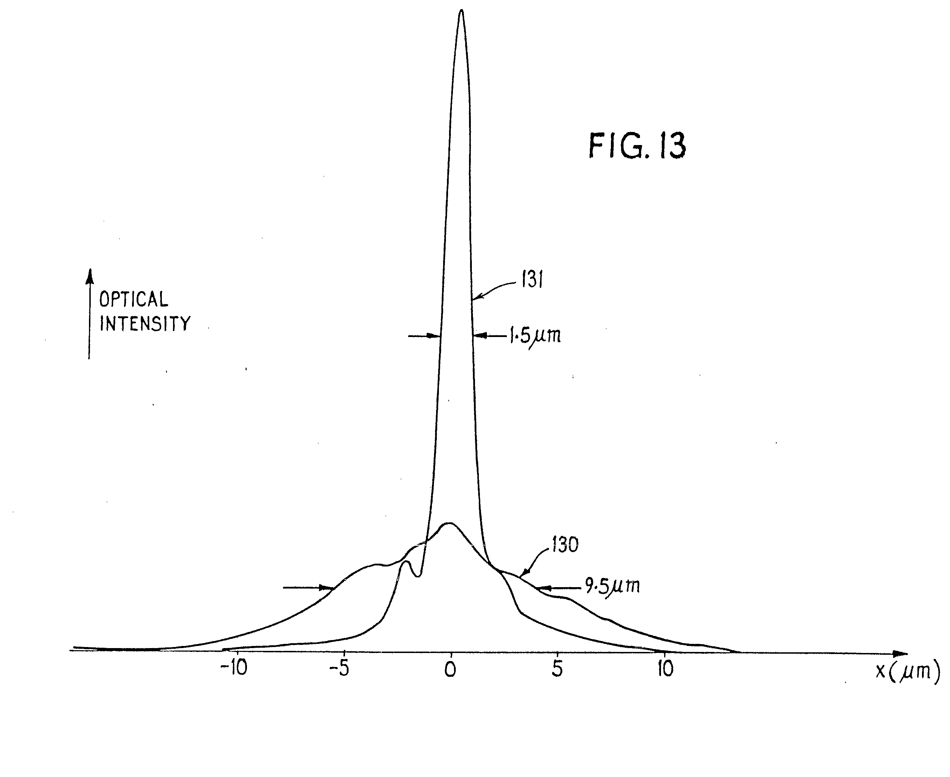

Fig. 12 shows plots, respectively in the plane of the active layer and normal to that plane, of the near field pattern of a single narrow stripe laser viewed through a plano-convex silica microlens having a thickness of 74 microns and a radius of curvature of 72 microns. These plots were measured using a NA = 0.5 microscope objective. The near-field distribution is 1.2 microns by 1.1 microns, and shows that at the same output power the intensity (power density) has been increased by a factor of between 5 and 10 by the addition of the microlens. The uncertainty in the factor of improvement in intensity arises from the fact that the measurements were limited by the resolution of the equipment; the same measurement carried out with a NA = 0.9 microscope objective resulted in a distribution of 1.0 microns by 0.8 microns. Fig 13 shows, for another single narrow stripe laser, the reduction in width of the near field pattern produced by use of a microlens. The intensity distribution plotted in the transverse direction is given by trace 130 in the absence of the microlens, and by trace 131 once the microlens has been fitted.

A feature of this use of a microlens adjacent the laser output facet is that it receives all the light emitted from that facet, and reduces from about $50^{\circ}$ to about $30^{\circ}$ the angle between the half power points in the polar diagram of the far field pattern measured in the plane containing the axis of the laser and the normal to the plane of its active layer. This is useful in the coupling of power from such a laser into a single mode optical fibre, or one capable of supporting only a few modes. A typical single mode fibre having a NA = 0.18 will have a core diameter of about 4 microns and will accept light over an angle of about $20^{o}$. The laser and the microlens combination emits over a wider angle,but its near field pattern is small enough to be imaged with a lens to form a larger image with a smaller cone of emission; the image being smaller than the core, and the cone being smaller than the acceptance angle of the fibre.

It is to be noted that although many of the features of the above described single narrow stripe laser devices make them suitable for optical fibre communications use, this is not the only application for such devices. Another important application lies in the field of systems requiring the scanning of a small spot of high intensity light, optionally one whose intensity can readily be modulated. Such systems are required for instance in certain forms of video disc recorder and in laser graphics systems involving the use of a laser beam to write information on to a photo-sensitive film.

CLAIMS:

1. A single narrow stripe contact double heterostructure injection laser device including a laser chip and associated astigmatic lens wherein the stripe contact is sufficiently narrow for there to be no significant plateau in the injected carrier distribution profile measured across the width of the laser at the lasing threshold current, characterised in that the astigmatic lens is a microlens located adjacent the output facet of the laser, and in that the astigmatic power and positioning of the microlens is such as to compensate the natural astigmatism of the laser output beam.

2. A laser device as claimed in claim 1 characterised in that the laser chip is bonded to a heat sink provided with a front surface substantially flush with the output facet of the laser.

3. A laser device as claimed in claim 2 characterised in that the microlens is bonded to the front surface of the heat sink.

4. A laser device as claimed in claim 1, 2, or 3 characterised in that the microlens is a plano-convex cylindrical microlens.

5. A laser device as claimed in claim 4 characterised in that the thickness of the lens is substantially matched with its radius of curvature.

6. A laser device as claimed in any preceding claim characterised in that the microlens forms part of a compound lens system which forms an enlarged image of the near field pattern of the laser viewed through the microlens, the size and emission cone angle of which image matches the core size and acceptance angle of a single mode optical fibre having a numerical aperture of 0.18.

7. A laser device as claimed in any preceding claim characterised in that the laser chip is made of $Ga_{1-x}Al_xAs$ ($x \geq 0$).

Au
Pd
Ti
SiO2/Si3N4
p-GaAs
p-Ga0·65Al0·35As
p-Ga0·95Al0·05As
n-Ga0·65Al0·35As
n-GaAs
19
18
17
16
15
14
13
12
11
50°x25°

FIG.1

19
18
17
16
15
14
13
12
11
Au
Pd
$TiO_2$
$SiO_2/Si_3N_4$
p-GaAs
p-$Ga_{0.65}Al_{0.35}As$
p-$Ga_{0.95}Al_{0.05}As$
n-$Ga_{0.65}Al_{0.35}As$
n-GaAs
50°x6°

FIG.2

3/10

2·05nm
0·45nm
824.1nm

FIG.3

3μm
3μm
3μm
3μm
OXIDE
D.H.LAYERS
CURRENT DENSITY (kAcm⁻²)
3
2
1
0
1·5
1·0
0·5
0
DIELECTRIC CONSTANT δε (x10⁻²)
8
4
0
4
2
0
OPTICAL INTENSITY ARBITRARY UNITS
9μm
3·5μm
x (μm)
x(μm)
-10
-5
0
5
10
(a)
(b)

FIG.4

10mW
OPTICAL INTENSITY
3mW
-8
-4
0
+4
+8
x (μm)

FIG.5

180mA
160mA
140mA
120mA
OPTICAL INTENSITY
-30
-15
0
+15
+30
DEGREES

FIG.6

OPTICAL MEAN OUTPUT POWER 5mW (NA=0·5)
FUNDAMENTAL SIGNAL LEVEL
P MOD = 5mW PEAK-PEAK (m=0·5)
2ND. ORDER PRODUCT
3RD. ORDER PRODUCT
8dB
16dB
24dB
DETECTOR UNIT
OUTPUT POWER
dBm (ELECTRICAL)
-20
-30
-40
-50
-60
-70
-80
-90
-100
20
22
24
26
28
30
dBmA
10mA
25mA
MODULATION CURRENT PEAK-PEAK

FIG.7

y
80
X
83
82
Z
81

FIG.8

7/10

80
P
s
ℓ
83

FIG.10

80
Q
P
83
ℓ
a
s

FIG.9

FIG.11

LENS
THICKNESS
ℓ (μm)
140
120
100
80
60
40
20
0
20
40
60
80
100
120
140
160
180
200
LENS RADIUS r (μm)
a = 30 μm
a = 25 μm
a = 20 μm
a = 15 μm
$\ell = \frac{n}{2}\left(\sqrt{a^2 + 4ar(n-1)^{-1}} - a\right)$

1·2μm
1·1μm
OPTICAL
INTENSITY
-5
0
5
-5
0
5
x (μm)
(y μm)

FIG.12

FIG. 13
OPTICAL
INTENSITY
131
1.5μm
130
9.5μm
-10
-5
0
5
10
x(μm)

0017374

European Patent Office

# EUROPEAN SEARCH REPORT

Application number

EP 80 30 0812

| Category | DOCUMENTS CONSIDERED TO BE RELEVANT<br>Citation of document with indication, where appropriate, of relevant passages | Relevant to claim | CLASSIFICATION OF THE APPLICATION (Int. Cl. 3) |
|---|---|---|---|
| | APPLIED OPTICS, vol. 13, nr. 1, January 1974<br>NEW YORK (US)<br>L.G. COHEN et al.: "Microlenses for coupling junction lasers to optical fibers", pages 89-94<br>* Page 89, end of the first paragraph, left-hand column; figure 1b *<br>-- | 1,4,6 | H 01 S 3/06 |
| | ELECTRIC COMPONENTS AND APPLICATIONS, vol. 1, nr. 2, February 1979<br>EINDHOVEN (NL)<br>"Semiconductor laser creates its own lens", page 129<br>* Page 129 *<br>-- | 1,4,6 | TECHNICAL FIELDS SEARCHED (Int.Cl. 3)<br>H 01 S 3/06<br>3/19<br>H 01 L 33/00 |
| | IBM TECHNICAL DISCLOSURE BULLETIN, vol. 19, nr. 2, July 1976,<br>NEW YORK (US)<br>E.A. CUNNINGHAM: "Collimated light source with laser diode and micro-cylindrical lens", pages 625-626<br>* Pages 625-626 *<br>-- | 1 | |
| A | FR - A - 2 317 786 (LICENTIA)<br>* Page 3, lines 10-15; page 4, lines 15-18; page 5, lines 15-19; claim 1; figures 1-4 *<br>---- | 1,2,3,7 | CATEGORY OF CITED DOCUMENTS<br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br>&: member of the same patent family, corresponding document |

X The present search report has been drawn up for all claims

| Place of search | Date of completion of the search | Examiner |
|---|---|---|
| The Hague | 07.07.1980 | ARMITANO-GRIVEL |